# FASCICULE DE BREVET EUROPEEN

(11) **EP 3 047 301 B1**
(45) Date de publication et mention de la délivrance du brevet: **01.08.2018**
(21) Numéro de dépôt: 14784292.6
(22) Date de dépôt: 15.09.2014
(51) Int. Cl.: G01S 13/89, G01S 17/89, G01S 7/03, G01S 7/491, G01N 21/00, G01N 21/3581, G01N 22/00, G01S 13/88, G01V 8/00, H03H 19/00

(54) **CAPTEUR D'IMAGE TERAHERTZ**
TERAHERTZ-BILDSENSOR
TERAHERTZ IMAGE SENSOR

(30) Priorité: 17.09.2013 FR 1358918
(43) Date de publication de la demande: 27.07.2016
(73) Titulaire: Commissariat à l'Energie Atomique et aux Energies Alternatives, 75015 Paris (FR)
(72) Inventeur: ROSTAING, Jean-Pierre, F-38260 La Côte Saint-Andre (FR); MOLLARD, Anaïs, F-38360 Sassenage (FR)
(74) Mandataire: Cabinet Beaumont
(86) Numéro de dépôt international: PCT/FR2014/052292
(87) Numéro de publication internationale: WO 2015/040316

(56) Documents cités:
- US-A- 3 526 858
- FRANZ SCHUSTER ET AL: "A broadband THz imager in a low-cost CMOS technology", 2011 IEEE INTERNATIONAL SOLID-STATE CIRCUITS CONFERENCE (ISSCC), DIGEST OF TECHNICAL PAPERS, 20 février 2011 (2011-02-20), pages 42-43, XP032013630, DOI: 10.1109/ISSCC.2011.5746211 ISBN: 978-1-61284-303-2
- D.C. VON GRUNIGEN ET AL: "An integrated CMOS switched-capacitor bandpass filter based on N-path and frequency-sampling principles", IEEE JOURNAL OF SOLID-STATE CIRCUITS, vol. 18, no. 6, décembre 1983 (1983-12), pages 753-761, XP055128501, ISSN: 0018-9200, DOI: 10.1109/JSSC.1983.1052027

## Description

La présente demande de brevet revendique la priorité de la demande de brevet français FR13/58918 qui sera considérée comme faisant partie intégrante de la présente description.

### Domaine

La présente demande concerne les capteurs d'image térahertz.

### Exposé de l'art antérieur

Le domaine des fréquences térahertz s'étend de 100 GHz à 30 THz environ, ce qui correspond à des longueurs d'onde variant entre 0,01 mm et 3 mm.

Les rayonnements térahertz ont un fort pouvoir pénétrant. Ils permettent de voir à travers de nombreux matériaux non-conducteurs, tels que la peau, les vêtements, le papier, le bois, le carton, les plastiques, etc. Ce sont des rayonnements peu énergétiques et non-ionisants, ce qui les rend peu nocifs, et, en particulier, utilisables dans les domaines de la médecine et de la sécurité.

Les rayonnements térahertz peuvent être utilisés dans de nombreuses applications, notamment dans le domaine des télécommunications à haut débit, des réseaux sans fils, des radars, de la surveillance de l'environnement, des tests biomédicaux, de la caractérisation des matériaux, de la détection de gaz ou de polluants, de la lutte contre le terrorisme, de l'observation astronomique, etc.

Un effort de recherche important est actuellement mené pour développer des sources et des détecteurs térahertz, en particulier pour développer des capteurs matriciels d'images térahertz à faible coût.

La publication de Franz Schuster et al intitulée "A broadbad THz imager in a low-cost CMOS technology" (2011 International Solid-State Circuits Conférence, pages 42-43) décrit des capteurs d'image térahertz. La publication de D.C. Von Grunigen et al intitulée "An integrated CMOS switched-capacitor bandpass filter based on N-path and frequency-sampling principles" (IEEE, Journal of Solid-State Circuits, vol. 18, n°6, décembre 1983) et le document US 3 526 858 décrivent chacun un filtre passe-bande à N chemins.

### Résumé

Un mode de réalisation prévoit un capteur matriciel d'image térahertz comprenant une matrice de pixels et comprenant, pour chaque pixel, une antenne de réception d'un rayonnement térahertz modulé par un signal à une fréquence de modulation et un filtre synchrone à N chemins, où N est un nombre entier supérieur ou égal à 4, chaque chemin comprenant un élément capacitif et au moins un premier interrupteur commandé par un premier signal à ladite fréquence de modulation.

Selon un mode de réalisation, chaque chemin comprend, en outre, un premier élément résistif.

Selon un mode de réalisation, chaque chemin comprend le premier interrupteur en série avec l'élément capacitif, plusieurs chemins étant disposés en parallèle entre un premier noeud et une source d'un potentiel de référence.

Selon un mode de réalisation, le filtre synchrone comprend, en outre, un deuxième élément résistif relié au premier noeud.

Selon un mode de réalisation, le deuxième élément résistif est réalisé par un circuit à capacité commutée.

Selon un mode de réalisation, le capteur comprend :
un premier ensemble de N/2 chemins, les chemins du premier ensemble étant disposés en parallèle entre le premier noeud et la source du potentiel de référence ;
un deuxième interrupteur entre un deuxième noeud et le premier noeud et un troisième interrupteur entre le premier noeud et un troisième noeud ;
un deuxième ensemble de N/2 chemins, les chemins du deuxième ensemble étant disposés en parallèle entre un quatrième noeud et la source du potentiel de référence ; et
un quatrième interrupteur entre le deuxième noeud et le quatrième noeud et un cinquième interrupteur entre le quatrième noeud et le troisième noeud.

Selon un mode de réalisation, le capteur comprend un circuit de commande des deuxième et troisième interrupteurs par un deuxième signal et des quatrième et cinquième interrupteurs par un troisième signal, les deuxième et troisième signaux étant à la fréquence de modulation et étant non recouvrants.

Selon un mode de réalisation, le capteur est réalisé de façon intégrée.

Selon un mode de réalisation, la fréquence de modulation est comprise entre 10 kHz et 1 MHz.

Selon un mode de réalisation, le capteur comprend, pour chaque pixel, un détecteur adapté à fournir un signal représentatif du rayonnement modulé et au moins un amplificateur recevant le signal représentatif et adapté à fournir un signal amplifié, le filtre synchrone recevant le signal amplifié.

Selon un mode de réalisation, le rayonnement, en l'absence de modulation, a une fréquence comprise entre 100 GHz à 30 THz.

Un mode de réalisation prévoit également un système d'imagerie térahertz d'un objet comprenant :
une source d'un rayonnement térahertz modulé par un signal à une fréquence de modulation ; et
un capteur du rayonnement térahertz modulé renvoyé par l'objet tel que défini précédemment.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, sous la forme d'un schéma-bloc, un mode de réalisation d'un dispositif d'imagerie térahertz ;
la figure 2 représente, sous la forme d'un schéma-bloc, un mode de réalisation d'une partie du capteur d'image térahertz du dispositif d'imagerie de la figure 1 ;
la figure 3 représente, de façon schématique, l'antenne, le détecteur et le préamplificateur du capteur d'image de la figure 2 ;
la figure 4 représente un mode de réalisation du filtre synchrone du capteur d'image de la figure 2 ;
la figure 5 est un chronogramme de signaux de commande du filtre de la figure 4 ;
la figure 6 représente des courbes d'évolution d'un signal d'entrée et d'un signal de sortie du filtre synchrone de la figure 4 ;
la figure 7 représente un exemple de courbe d'évolution du gain du filtre synchrone de la figure 4 ;
les figures 8 et 9 représentent d'autres modes de réalisation du filtre du capteur d'image de la figure 2 ;
la figure 10 représente, sous la forme d'un schéma-bloc, un mode de réalisation d'une autre partie du capteur d'image térahertz du dispositif d'imagerie de la figure 1 ;
les figures 11 et 12 illustrent le principe de fonctionnement d'un circuit de masse virtuelle ;
la figure 13 représente un mode de réalisation du circuit de masse virtuelle du capteur d'image de la figure 10 ; et
la figure 14 est une vue de dessus, partielle et schématique, d'un mode de réalisation intégré d'un capteur d'image térahertz.

### Description détaillée

Par souci de clarté, de mêmes éléments ont été désignés par de mêmes références aux différentes figures et, de plus, les diverses figures ne sont pas tracées à l'échelle. Dans la suite de la description, sauf indication contraire, les termes "sensiblement", "environ" et "de l'ordre de" signifient "à 10 % près". En outre, seuls les éléments utiles à la compréhension de la présente description ont été représentés et sont décrits. En particulier, le traitement des signaux fournis par un capteur matriciel d'images, notamment pour l'affichage d'une image, est bien connu de l'homme du métier et n'a pas été décrit plus en détails.

Les signaux susceptibles d'être mesurés par un capteur de rayonnement térahertz ont généralement une amplitude faible, voisine du bruit. Un traitement de ces signaux doit donc être mis en oeuvre pour extraire le signal utile du bruit. On pourrait envisager de mettre en oeuvre un procédé de détection synchrone dans lequel le rayonnement térahertz émis par la source de rayonnement est modulé par un signal de porteuse et dans lequel le signal utile est extrait du signal mesuré en multipliant le signal mesuré par un signal de commande à la fréquence du signal de porteuse.

Toutefois, les inventeurs ont mis en évidence qu'un tel procédé de démodulation synchrone ne peut pas être mis en oeuvre pour la réalisation d'un capteur matriciel d'image térahertz à coût réduit, et en particulier réalisé de façon intégrée. En effet, l'étape de multiplication nécessite que le signal de commande avec lequel le signal mesuré est multiplié soit en phase avec le signal mesuré. Ceci ne peut pas être obtenu de façon simple avec un capteur d'image matriciel.

Un capteur d'image matriciel est constitué d'une matrice de pixels, un pixel correspondant à un site du capteur, sensible au rayonnement térahertz et ayant les dimensions les plus petites. Les dimensions du pixel définissent la résolution spatiale de l'image térahertz obtenue. Comme le signal détecté par un pixel a une amplitude très faible, le capteur comprend, pour chaque pixel, un dispositif d'amplification comportant, par exemple, un préamplificateur à faible bruit, qui reçoit le signal fourni par le détecteur du rayonnement térahertz, suivi d'un amplificateur à gain variable.

Toutefois, l'amplification du signal détecté peut entraîner un déphasage qui dépend du gain d'amplification choisi et qui peut, en outre, varier d'un pixel à l'autre pour un même gain d'amplification. Il n'est pas envisageable, pour la réalisation d'un capteur d'image térahertz à coût réduit, de corriger la phase du signal de commande à chaque changement de gain d'amplification et pour chaque pixel.

La présente invention prévoit de moduler le rayonnement térahertz émis par la source de rayonnement par un signal de porteuse et de filtrer le signal mesuré à la fréquence du signal de porteuse par un filtre passe-bande très sélectif.

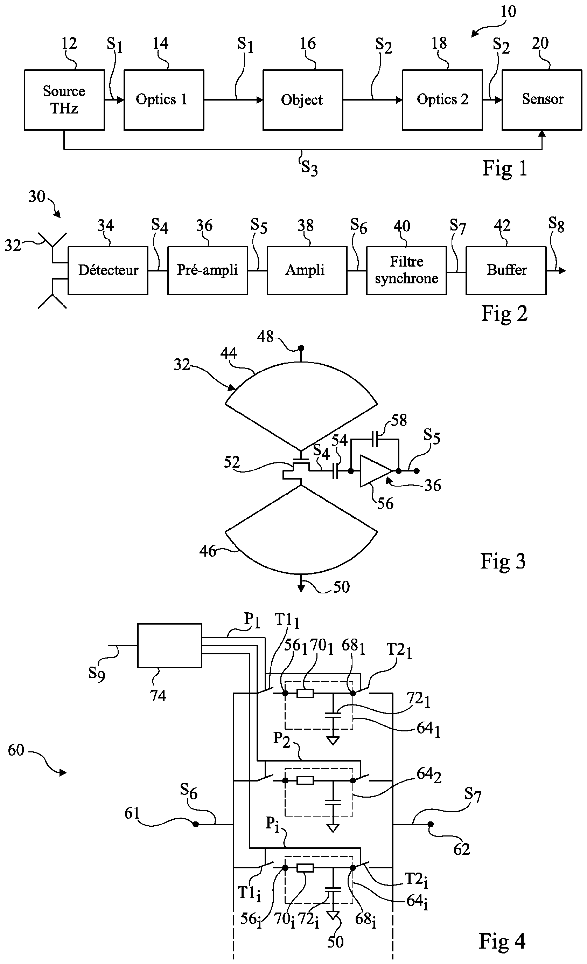

La figure 1 représente, sous la forme d'un schéma-bloc, un mode de réalisation d'un dispositif d'imagerie térahertz 10.

Le dispositif 10 comprend une source 12 (Source THz) d'un rayonnement térahertz, par exemple à une fréquence comprise entre 100 GHz et 30 THz. Le rayonnement térahertz est modulé, par exemple par modulation d'amplitude, par un signal de porteuse à une fréquence de modulation f₀ comprise entre 10 kHz et 1 MHz, de préférence comprise entre 10 kHz et 500 kHz, plus préférentiellement comprise entre 10 kHz et 200 kHz, par exemple d'environ 100 kHz. Le rayonnement modulé S₁ est guidé par un système optique 14 (Optics 1) jusqu'à un objet 14 (Object) à analyser. Le rayonnement S₂ renvoyé par l'objet 16 est guidé par un système optique 18 (Optics 2) jusqu'à un capteur d'image térahertz 20 (Sensor). Le capteur 20 peut, en outre, recevoir un signal S₃ à la fréquence f₀ fourni par la source 12.

La figure 2 représente, sous la forme d'un schéma-bloc, un mode de réalisation d'un circuit 30 correspondant à une partie du capteur 20. Le circuit 30 est prévu pour chaque pixel du capteur d'image 20. Le circuit 30 de chaque pixel comprend une antenne 32, recevant le rayonnement térahertz modulé S₂, reliée à un détecteur 34 (Détecteur). Le détecteur 34 fournit un signal S₄ qui comprend un signal utile, représentatif du rayonnement térahertz modulé qui a été mesuré, noyé dans du bruit. Le signal S₄ est un signal qui peut avoir une amplitude variant par exemple de quelques microvolts à quelques millivolts selon l'exposition du capteur 20. Le signal S₄ doit être amplifié. Ceci peut être réalisé par plusieurs étages d'amplification successifs. A titre d'exemple, le circuit 30 comprend un préamplificateur à faible bruit 36 (Pré-ampli) recevant le signal S₄ et fournissant un signal S₅ à un amplificateur 38 à gain variable (Ampli). L'amplificateur 38 fournit un signal S₆ à un filtre synchrone 40 (Filtre synchrone). Le filtre synchrone 40 fournit un signal S₇ à un circuit adaptateur 42 (Buffer). Le circuit adaptateur 42 fournit un signal S₈ à un circuit décrit par la suite, qui peut être commun à plusieurs pixels du capteur 20.

La figure 3 représente un mode de réalisation de l'antenne 32, du détecteur 34 et du préamplificateur 36. L'antenne 32 peut comprendre deux secteurs angulaires 44, 46 d'un matériau conducteur, par exemple deux secteurs angulaires métalliques. Le bord circulaire du secteur angulaire 44 est connecté à une source 48 d'un potentiel de référence haut. Le bord circulaire du secteur angulaire 46 est connecté à une source 50 d'un potentiel de référence bas, par exemple la masse du circuit 30. Le détecteur 34 peut correspondre à un transistor à effet de champ, par exemple un transistor MOS. La source du transistor 52 est connectée au sommet du secteur angulaire 46. Le drain du transistor 52 fournit le signal S₄ et est connecté à l'entrée du pré-amplificateur 36. La grille du transistor 52 est connectée au sommet du secteur angulaire 44. Selon le présent mode de réalisation, le pré-amplificateur 36 comprend un condensateur 54 dont une électrode reçoit le signal S₄ et dont l'autre électrode est reliée à l'entrée d'un amplificateur 56 dont la sortie fournit le signal S₅. Le pré-amplificateur 36 comprend un condensateur supplémentaire 58 dont une électrode est reliée à l'entrée de l'amplificateur 56 et dont l'autre électrode est reliée à la sortie de l'amplificateur 56. Le gain d'amplification du préamplificateur 36 peut être supérieur ou égal à 10, de préférence supérieur ou égal à 20. De par son fonctionnement, le préamplificateur 56 peut, en outre, jouer le rôle d'un filtre passe-bas et bloquer les fréquences supérieures à quelques mégahertz.

L'amplificateur 38 peut réaliser une amplification avec un gain d'amplification qui peut prendre plusieurs valeurs discrètes entre 1 et 100. A titre d'exemple, l'amplificateur 38 peut comprendre plusieurs étages d'amplification, par exemple trois étages d'amplification. Chaque étage d'amplification peut comprendre un amplificateur à transconductance et des condensateurs, au moins l'un des condensateurs pouvant être court-circuité pour modifier le gain d'amplification de l'étage.

Le filtre synchrone 40 recevant le signal S₆ est un filtre passe-bande à bande étroite centrée sur la fréquence de modulation f₀ pour supprimer le bruit en dehors de cette fréquence. Le filtre synchrone 40 est un filtre à N chemins (en anglais N-Path Filter), chaque chemin comprenant un élément capacitif à commuter, et où N est un nombre entier supérieur ou égal à 4. De préférence, N est une puissance de 2, telle que 4, 8, 16, 32, etc. Le filtre synchrone 40 est commandé par un signal de commande S₉ qui est un signal d'horloge à la fréquence N*f₀. A titre de variante, le capteur 20 peut ne pas recevoir le signal S₃ fourni par la source 12 et le capteur 20 peut comprendre un circuit de fourniture du signal S₉. De façon avantageuse, le filtre synchrone 40 fonctionne indépendamment du déphasage entre le signal S₆ et le signal de commande S₉.

La figure 4 représente un mode de réalisation d'un circuit 60 pouvant correspondre au filtre synchrone 40 de la figure 2. Le filtre 60 comprend un noeud d'entrée 61 recevant le signal S₆ et un noeud de sortie 62 fournissant le signal S₇. Le filtre 60 comprend N filtres élémentaires 64ᵢ, i variant de 1 à N. Chaque filtre élémentaire 64ᵢ comprend un noeud d'entrée 66ᵢ et un noeud de sortie 68ᵢ. Le noeud d'entrée 66ᵢ est relié au noeud 61 par un premier interrupteur T1ᵢ et le noeud de sortie 68ᵢ est relié au noeud 62 par un deuxième interrupteur T2ᵢ. Les interrupteurs T1ᵢ et T2ᵢ peuvent être réalisés par des transistors MOS.

Chaque filtre élémentaire 64ᵢ peut correspondre à un filtre passe-bas comprenant, à titre d'exemple, un élément résistif 70ᵢ entre les noeuds 66ᵢ et 68ᵢ et un élément capacitif 72ᵢ dont une électrode est reliée au noeud 68ᵢ et dont l'autre électrode est reliée à la source 50 du potentiel de référence bas. Tous les éléments résistifs 70ᵢ peuvent avoir la même valeur de résistance R et tous les éléments capacitifs 72ᵢ peuvent avoir la même capacité C. On entend par élément résistif un élément qui a un comportement résistif et on entend par élément capacitif un élément qui a un comportement capacitif. Chaque élément résistif peut correspondre à une résistance et chaque élément capacitif peut correspondre à un condensateur.

Les interrupteurs T1ᵢ et T2ᵢ sont commandés par un signal Pᵢ. Les signaux Pᵢ, i variant de 1 à N, sont fournis par un circuit 74 recevant le signal S₉. Les signaux Pᵢ sont par exemple des signaux binaires alternant entre un état "haut" et un état "bas". A titre d'exemple, chaque interrupteur T1ᵢ et T2ᵢ est ouvert lorsque le signal Pᵢ est à l'état bas et est fermé lorsque le signal Pᵢ est à l'état haut. Les signaux Pᵢ sont non recouvrants, c'est-à-dire que lorsqu'un signal Pᵢ est à l'état haut, tous les autres signaux Pⱼ, avec j différent de i, sont à l'état bas. A titre d'exemple, le circuit 74 comprend un compteur, un décodeur et des bascules anti-recouvrement.

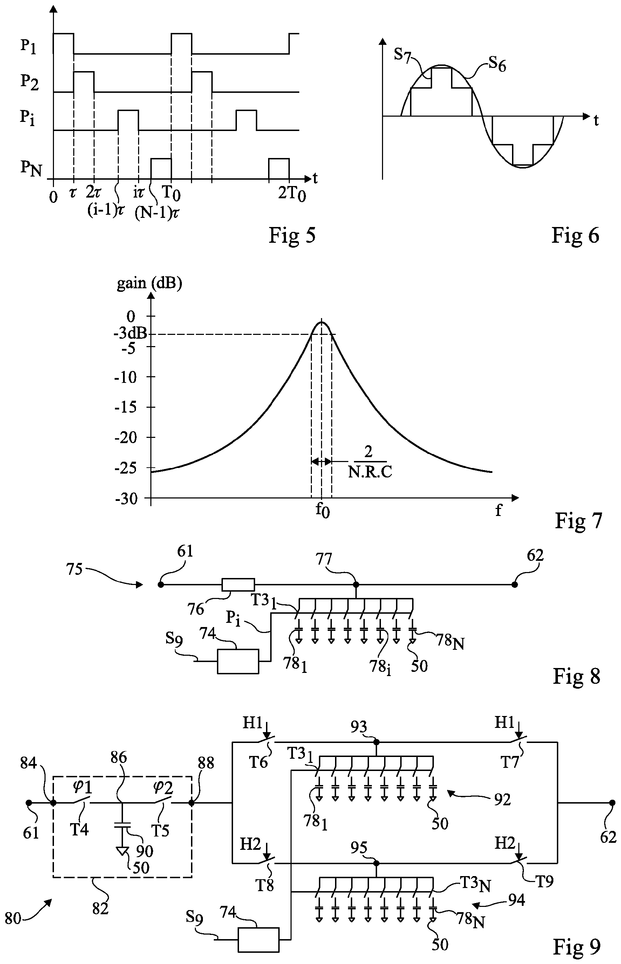

La figure 5 représente un exemple de chronogramme des signaux Pᵢ. Les signaux Pᵢ sont des signaux binaires périodiques de période T₀ égale à 1/f₀. A titre d'exemple, le signal P₁ est à l'état haut entre les instants 0 et τ puis est à l'état bas jusqu'à l'instant T₀, où τ est sensiblement égal à T₀/N. Le signal P₂ est à l'état bas entre les instants 0 et τ puis est à l'état haut entre les instants τ et 2τ puis à nouveau à l'état bas jusqu'à l'instant T₀+τ. Le signal Pᵢ est à l'état bas entre les instants 0 et (i-1)τ puis à l'état haut pendant la durée τ puis à nouveau à l'état bas jusqu'à l'instant T₀+(1-1)τ. Le signal P_{N} est à l'état bas entre les instants 0 et (N-1)τ puis à l'état 0 pendant la durée τ puis à nouveau à l'état bas jusqu'à l'instant T₀+(N-1)τ.

Chaque filtre élémentaire 64ᵢ est donc parcouru cycliquement pendant une durée τ par le signal S₆. La constante de temps du filtre passe-bas 64ᵢ est choisie grande devant la période de commutation T₀. On obtient alors une transformation de passe-bas en passe-bande du fait du balayage cyclique.

Le principe de fonctionnement du filtre synchrone 60 est le suivant. Si le signal S₆ correspond à un signal sinusoïdal avec une fréquence égale à f₀, chaque condensateur 72ᵢ est alors sollicité, à chaque période T₀, par la même partie du signal S₆ qui revient à chaque cycle. Pendant une phase d'initialisation, le condensateur 72ᵢ se charge un peu pendant l'intervalle de temps T₀/N du cycle et maintient cette charge le reste du temps. En régime établi, la tension aux bornes du condensateur 72ᵢ a rejoint la valeur moyenne du signal S₆ à laquelle elle est sollicitée. On obtient sur le noeud de sortie 62 la forme approchée du signal d'entrée S₆ échantillonnée par valeurs discrètes régulièrement réparties sous la forme de marches en escalier.

La figure 6 représente un exemple de courbes d'évolution des signaux S₆ et S₇ fournis par le filtre synchrone 60 dans le cas où le signal S₆ correspond à un signal sinusoïdal de fréquence f₀.

Quand la fréquence du signal d'entrée S₆ diffère de la fréquence f₀, chaque condensateur 72ᵢ est sollicité par une valeur du signal d'entrée S₆ qui glisse progressivement d'un cycle à l'autre et prend successivement toutes les valeurs de la sinusoïde. Si la différence est grande, les condensateurs 72ᵢ ne peuvent pas accumuler une charge appréciable et la tension aux bornes de chaque condensateur 72ᵢ tend vers une valeur moyenne nulle. Pour le capteur 20, le signal S₆ correspond au signal utile noyé dans du bruit. Le signal S₇ correspond alors à la raie du signal S₆ à la fréquence f₀.

La figure 7 représente un exemple de courbe d'évolution du gain du filtre 60 en fonction de la fréquence. La fonction de transfert du filtre est symétrique par rapport à la fréquence f₀. Le facteur de mérite Q du filtre 60 dépend des valeurs R et C et du nombre N de chemins. Il est égal à 2/(NRC). Le facteur de mérite Q est supérieur ou égal à 100, de préférence supérieur ou égal à 300, plus préférentiellement supérieur ou égal à 500. La vitesse de variation de la tension aux bornes de chaque condensateur 72ᵢ évolue selon la constante de temps du filtre passe-bas élémentaire 64ᵢ, c'est-à-dire du produit RC. Le filtre 60 est donc d'autant plus lent qu'il est sélectif.

En changeant la fréquence de commutation N*f₀, il est possible de modifier la fréquence centrale f₀ du filtre passe-bande sans changer la largeur de la bande passante. Outre la réponse du filtre passe-bande centrée à la fréquence f₀, le filtre 60 produit une série de raies centrées sur les harmoniques de f₀ et à la fréquence nulle. Comme le filtre échantillonne à la fréquence d'horloge N*f₀, les problèmes de repliement de spectre peuvent être résolus en limitant par filtrage à temps continu (en anglais anti-aliasing) le spectre d'entrée à une fréquence inférieure à N*f₀/2.

La figure 8 représente un autre mode de réalisation d'un filtre synchrone 75 à N chemins pouvant être utilisé pour réaliser le filtre 40 de la figure 2. Le filtre 75 comprend un élément résistif 76 entre le noeud 61 et un noeud intermédiaire 77 relié au noeud 62. Le filtre 75 comprend N chemins parallèles, chaque chemin comprenant un condensateur 78ᵢ et un interrupteur T3ᵢ. Une électrode du condensateur 78ᵢ est reliée à la source 50 du potentiel de référence bas et l'autre électrode est reliée à une borne de l'interrupteur T3ᵢ, l'autre borne de l'interrupteur T3ᵢ étant reliée au noeud 77. Chaque interrupteur T3ᵢ est commandé par le signal Pᵢ fourni par le circuit 74. L'élément résistif 76 a la valeur de résistance R et chaque condensateur 78ᵢ a la capacité C. Le filtre 75 fonctionne de la même façon que le filtre 60 décrit précédemment. Par rapport au filtre 60, le filtre 75 présente l'avantage que l'élément résistif 76 est mis en commun pour l'ensemble des N chemins du filtre et que le nombre d'interrupteurs est réduit.

La figure 9 représente un autre mode de réalisation d'un filtre synchrone 80 à N chemins pouvant être utilisé pour réaliser le filtre 40 de la figure 2. Par rapport au filtre 75, l'élément résistif 76 est réalisé par un circuit à capacité commutée 82 comprenant un noeud d'entrée 84 relié au noeud 61, un noeud intermédiaire 86 et un noeud de sortie 88. Le circuit 82 comprend un interrupteur T4 commandé par un signal ϕ₁ entre le noeud d'entrée 84 et le noeud intermédiaire 86 et un interrupteur T5 commandé par un signal binaire ϕ₂ entre le noeud intermédiaire 86 et le noeud de sortie 88. Le circuit 82 comprend, en outre, un condensateur 90 entre le noeud intermédiaire 86 et la source 50 du potentiel de référence bas. Les signaux ϕ₁ et ϕ₂ sont non recouvrants et sont des signaux binaires de fréquence f₁. La fréquence f₁ est supérieure à la fréquence f₀. De préférence, la fréquence f₁ est un multiple de la fréquence f₀ pour éviter des phénomènes parasites d'intermodulation. La valeur de la résistance équivalente est R= 1/C₉₀f₁ où C₉₀ est la capacité du condensateur 90.

Par rapport au filtre 75, les N chemins comprenant chacun le condensateur 78ᵢ et l'interrupteur T3ᵢ sont répartis en deux sous-ensembles 92 et 94 comprenant chacun N/2 chemins. Les N/2 chemins du sous-ensemble 92 sont prévus en parallèle entre un noeud 93 et la source 50 du potentiel de référence bas et les N/2 chemins du sous-ensemble 94 sont prévus en parallèle entre un noeud 95 et la source 50 du potentiel de référence bas. Le filtre 80 comprend, en outre, un interrupteur T6 entre le noeud 88 et le noeud 93 et un interrupteur T7 entre le noeud 93 et le noeud de sortie 62. Les interrupteurs T6 et T7 sont commandés par un signal binaire H1. Le filtre 80 comprend, en outre, un interrupteur T8 entre le noeud 88 et le noeud 95 et un interrupteur T9 entre le noeud 95 et le noeud de sortie 62. Les interrupteurs T8 et T9 sont commandés par un signal binaire H2. Les signaux H1 et H2 sont non recouvrants et de périodes T₀. A titre d'exemple, le rapport cyclique de chaque signal H1 et H2 est légèrement inférieur à 1/2. Le fait de prévoir deux ensembles de N/2 condensateurs 78ᵢ permet de réduire les capacités parasites vues depuis le noeud 88.

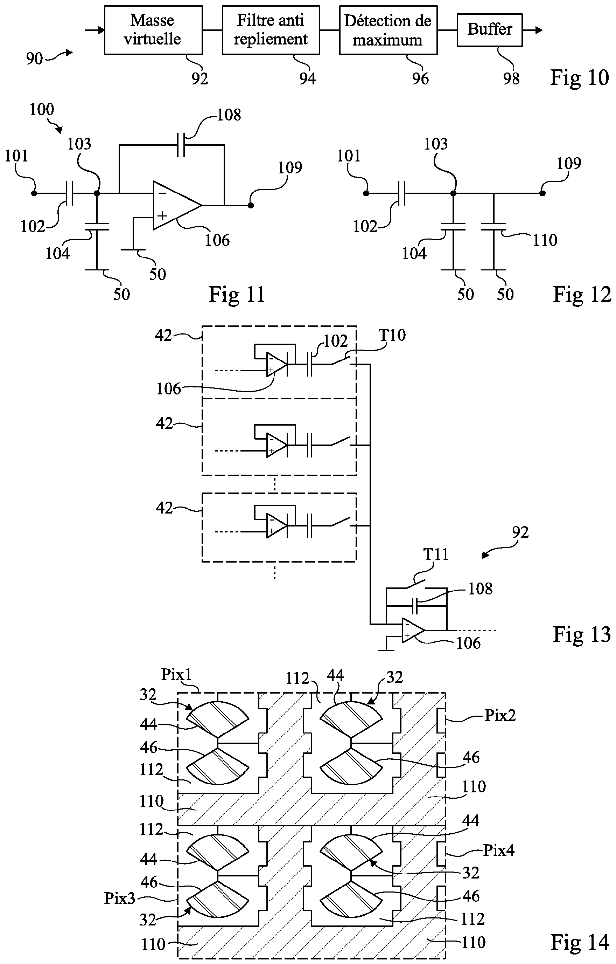

La figure 10 représente, sous la forme d'un schéma-bloc, un circuit 90 correspondant à une autre partie du capteur 20 de la figure 1. Le circuit 90 peut être commun pour un ensemble de pixels du capteur 20, par exemple pour les pixels d'une même colonne de pixels. Dans ce cas, le circuit 90 est reproduit pour chaque colonne de pixels du capteur 20.

Le circuit 90 comprend successivement un circuit de masse virtuelle 92 (Masse virtuelle), un filtre anti-repliement 94 (Filtre anti-repliement), un circuit de détection de maximum 96 (Détection de maximum) et un circuit adaptateur 98 (Buffer).

Le circuit de masse virtuelle 92 est relié à la sortie du circuit adaptateur 42 associé à chaque pixel d'un ensemble de pixels, par exemple à chaque pixel d'une même colonne de pixels du capteur 20. Le circuit 92 permet de s'affranchir de la capacité parasite de la ligne connectée à l'ensemble des pixels de la colonne.

La figure 11 représente un circuit 100 illustrant le principe de fonctionnement d'une masse virtuelle. On a représenté un condensateur 102 entre un noeud 101 et un noeud 103, un condensateur 104 entre le noeud 103 et la source 50 du potentiel de référence bas, un amplificateur à transconductance 106 dont l'entrée inverseuse (-) est reliée au noeud 103 et dont l'entrée non-inverseuse (+) est reliée à la source 50 du potentiel de référence bas. Un condensateur 108 est relié entre le noeud 103 et un noeud 109 qui correspond à la sortie de l'amplificateur 106. En fonctionnement, le circuit 100 est équivalent au circuit représenté à la figure 12 dans lequel le condensateur 108 et l'amplificateur 106 sont remplacés par un condensateur 110 connecté entre le noeud 103 et la source 50 de potentiel de référence bas. La capacité du condensateur 110 est égale au produit du gain en boucle ouverte de l'amplificateur 106 et de la capacité du condensateur 108. Si ce produit est supérieur à la capacité du condensateur 104, les effets dus au condensateur 104 sont négligeables.

Dans le présent mode de réalisation, le condensateur 104 est représentatif de la capacité parasite de la ligne connectée aux circuits adaptateurs 42 des pixels d'une colonne de la matrice de pixels et le condensateur 102 est un condensateur du circuit adaptateur 42. La capacité des condensateurs 102 et 108 est sensiblement égale pour obtenir un gain égal à 1 en valeur absolue.

La figure 13 représente un mode de réalisation du circuit de masse virtuelle 92. Le circuit adaptateur 42 de chaque pixel est schématiquement représenté par un amplificateur à transconductance 106 monté en suiveur de gain unitaire suivi du condensateur 102 et d'un interrupteur T10. Le circuit de masse virtuelle 92 comprend l'amplificateur à transconductance 106 et le condensateur 108. Il peut, en outre, comprendre un interrupteur T11 monté en parallèle du condensateur 108. En fonctionnement, les interrupteurs sont fermés successivement l'un à la suite de l'autre pour relier successivement chaque pixel au circuit 92. Le circuit de masse virtuelle 92 présente, en outre, l'avantage d'atténuer les signaux sur le bus. Ainsi, l'influence des signaux sinusoïdaux transmis sur les bus sur les pixels voisins est réduite.

Le filtre anti-repliement 94 peut comprendre un filtre passe-bas à temps continu dont la fréquence de coupure est supérieure à la fréquence f₀. Il permet de supprimer les raies aux harmoniques de la fréquence f₀.

Le circuit adaptateur 98 peut avoir une structure analogue au circuit adaptateur 42. Les signaux fournis par les circuits adaptateurs 98 peuvent être utilisés notamment pour l'affichage d'images sur un écran d'affichage.

Le circuit de détection de maximum 96 peut comprendre un circuit échantillonneur.

La figure 14 représente de façon schématique une vue de dessus de quatre pixels adjacents Pix1, Pix2, Pix3 et Pix4 d'un capteur 20 réalisé de façon intégrée, par exemple selon une technologie CMOS. La figure 14 n'est pas tracée à l'échelle. On a représenté, pour chaque pixel Pix1, Pix2, Pix3 et Pix4, les secteurs angulaires 44 et 46 de l'antenne 32 et par une zone hachurée 110, les emplacements où sont réalisés les transistors MOS et les condensateurs du circuit 30. Chaque condensateur 72ᵢ, 78ᵢ, peut correspondre à une capacité métal-isolant-semiconducteur ou capacité MOS et le condensateur 90 peut être réalisé par une capacité métal-isolant-métal ou capacité MIM.

Pour chaque pixel Pix1, Pix2, Pix3 et Pix4, une zone libre 112 est prévue autour de chaque antenne 32 pour réduire l'influence du circuit 30 sur le rayonnement mesuré et l'influence du rayonnement reçu sur le circuit 30. La zone libre 112 ne comprend pas de composants électroniques à l'exception du détecteur 12, éventuellement du préamplificateur 36, des pistes de polarisation de l'antenne 23 et de la piste reliant le préamplificateur 36 à l'amplificateur 38.

Des exemples de valeurs des composants des circuits 30 et 90 sont les suivantes :
- capacité du condensateur 54 : comprise entre 1 pF et 10 pF, par exemple environ 3 pF ;
- capacité du condensateur 58 : comprise entre 10 fF et 200 fF, par exemple environ 62 fF ;
- dimensions de chaque pixel : surface carrée ayant un côté compris entre 100 µm et 500 µm, par exemple d'environ 200 µm ;
- rayon de chaque secteur angulaire 44, 46 : compris entre 20 µm et 100 µm, par exemple environ 60 µm ;
- angle au sommet de chaque secteur angulaire 44, 46 : compris entre 90° et 180°, par exemple environ 120° ;
- capacité du condensateur 90 : comprise entre 2 pF et 20 pF, par exemple environ 10 pF ;
- fréquence f₁ : comprise entre 100 kHz et 10 MHz, par exemple d'environ 1,6 MHz ; et
- capacité de chaque condensateur 78ᵢ : comprise entre 5 fF et 100 fF, par exemple environ 27 fF.

La résistance équivalente du circuit 82 est d'environ 23 mégohms. Pour un nombre N de chemins égal à 16, le filtre synchrone 80 obtenu avec les valeurs particulières indiquées précédemment est un filtre passe-bande centré sur la fréquence f₀ dont le facteur de sélectivité est de l'ordre de 650.

Des modes de réalisation particuliers ont été décrits. Diverses variantes et modifications apparaîtront à l'homme de l'art. En particulier, bien qu'un mode de réalisation de l'antenne 32 ait été décrit dans lequel l'antenne 32 comprend deux secteurs angulaires 44, 46, la forme de l'antenne 32 peut être différente.

## Revendications

1. Capteur (20) matriciel d'image térahertz comprenant une matrice de pixels (Pix1, Pix2, Pix3, Pix4) et comprenant, pour chaque pixel, une antenne (32) de réception d'un rayonnement (S₂) térahertz modulé par un signal à une fréquence de modulation, **caractérisé en ce qu'**il comprend, en outre, un filtre passe-bande synchrone (40, 60, 75, 80) à N chemins, où N est un nombre entier supérieur ou égal à 4, chaque chemin comprenant un élément capacitif (72ᵢ, 78ᵢ) et au moins un premier interrupteur (T1ᵢ, T2ᵢ, T3ᵢ) commandé par un premier signal (Pᵢ) à ladite fréquence de modulation.

2. Capteur selon la revendication 1, dans lequel chaque chemin comprend, en outre, un premier élément résistif (70ᵢ).

3. Capteur selon la revendication 1, dans lequel chaque chemin comprend un des au moins un premier interrupteur (T3ᵢ) en série avec l'élément capacitif (78ᵢ), plusieurs chemins étant disposés en parallèle entre un premier noeud (77, 93, 95) et une source (50) d'un potentiel de référence.

4. Capteur selon la revendication 3, dans lequel le filtre passe-bande synchrone (75 ; 80) comprend, en outre, un deuxième élément résistif (76 ; 82) relié au premier noeud (77, 93, 95).

5. Capteur selon la revendication 4, dans lequel le deuxième élément résistif (82) est réalisé par un circuit à capacité commutée.

6. Capteur selon la revendication 4 ou 5, comprenant :
un premier ensemble de N/2 chemins, les chemins du premier ensemble étant disposés en parallèle entre le premier noeud (93) et la source (50) du potentiel de référence ;
un deuxième interrupteur (T6) entre un deuxième noeud (88) et le premier noeud (93) et un troisième interrupteur (T7) entre le premier noeud (93) et un troisième noeud (62) ;
un deuxième ensemble de N/2 chemins, les chemins du deuxième ensemble étant disposés en parallèle entre un quatrième noeud (95) et la source (50) du potentiel de référence ; et
un quatrième interrupteur (T8) entre le deuxième noeud (88) et le quatrième noeud (95) et un cinquième interrupteur (T9) entre le quatrième noeud (95) et le troisième noeud (62).

7. Capteur selon la revendication 6, comprenant un circuit de commande des deuxième et troisième interrupteurs (T6, T7) par un deuxième signal (H1) et des quatrième et cinquième interrupteurs (T8, T9) par un troisième signal (H2), les deuxième et troisième signaux étant à la fréquence de modulation et étant non recouvrants, c'est-à-dire que lorsque l'un des deuxième et troisième signaux est à l'état haut, l'autre des deuxième et troisième signaux est à l'état bas.

8. Capteur selon l'une quelconque des revendications 1 à 7, **caractérisé en ce qu'**il est réalisé de façon intégrée.

9. Capteur selon l'une quelconque des revendications 1 à 8, dans lequel la fréquence de modulation est comprise entre 10 kHz et 1 MHz.

10. Capteur selon l'une quelconque des revendications 1 à 9, comprenant, pour chaque pixel, un détecteur (34) adapté à fournir un signal (S₄) représentatif du rayonnement modulé et au moins un amplificateur (36, 38) recevant le signal représentatif et adapté à fournir un signal amplifié (S₆), le filtre passebande synchrone (40, 60, 75, 80) recevant le signal amplifié.

11. Capteur selon l'une quelconque des revendications 1 à 10, dans lequel le rayonnement, en l'absence de modulation, a une fréquence comprise entre 100 GHz à 30 THz.

12. Système (10) d'imagerie térahertz d'un objet (16) comprenant :
une source (12) d'un rayonnement térahertz modulé par un signal à une fréquence de modulation ; et
un capteur (20) du rayonnement térahertz modulé renvoyé par l'objet selon l'une quelconque des revendications 1 à 11.

## Patentansprüche

1. Eine Terahertz-Bildsensoranordnung (20), die Folgendes aufweist: eine Anordnung von Pixeln (Pix1, Pix2, Pix3, Pix4) und für jedes Pixel eine Antenne (32) zum Empfangen einer Terahertz-Strahlung (S₂), die von einem Signal mit einer Modulationsfrequenz moduliert ist, **dadurch gekennzeichnet, dass** sie einen N-Pfad-Synchronfilter (40, 60, 75, 80), wobei N eine ganze Zahl größer oder gleich 4 ist und jeder Pfad ein kapazitives Element (72ᵢ, 78ᵢ) und wenigstens einen ersten Schalter (T1ᵢ, T2ᵢ, T3ᵢ) aufweist, der von einem ersten Signal (Pᵢ) mit der Modulationsfrequenz gesteuert wird.

2. Sensor nach Anspruch 1, wobei jeder Pfad ferner ein erstes Widerstandselement (70ᵢ) aufweist.

3. Sensor nach Anspruch 1, wobei jeder Pfad Folgendes aufweist: einen von der wenigstens einen ersten Schalter (T3ᵢ) in Reihe mit dem kapazitiven Element (78ᵢ) und eine Vielzahl von Pfaden, die parallel zwischen einem ersten Knoten (77, 93, 95) und einer Quelle (50) eines Referenzpotentials angeordnet sind.

4. Sensor nach Anspruch 3, wobei der Synchronfilter (75; 80) ferner ein zweites Widerstandselement (76; 82), das mit dem ersten Knoten (77, 93, 95) verbunden ist, aufweist.

5. Sensor nach Anspruch 4, wobei das zweite Widerstandselement (82) durch eine Schaltung mit geschaltetem Kondensator gebildet ist.

6. Sensor nach Anspruch 4 oder 5, der Folgendes aufweist:
einen ersten Satz von N/2 Pfaden, wobei die Pfade des ersten Satzes parallel zwischen dem ersten Knoten (93) und der Quelle (50) des Referenzpotentials angeordnet sind;
einen zweiten Schalter (T6) zwischen einem zweiten Knoten (88) und dem ersten Knoten (93) und einen dritten Schalter (T7) zwischen dem ersten Knoten (93) und dem dritten Knoten (62);
einen zweiten Satz von N/2 Pfaden, wobei die Pfade des zweiten Satzes parallel zwischen einem vierten Knoten (95) und der Quelle (50) des Referenzpotentials angeordnet sind; und
einen vierten Schalter (T8) zwischen dem zweiten Knoten (88) und dem vierten Knoten (95) und einen fünften Schalter (T9) zwischen dem vierten Knoten (95) und dem dritten Knoten (62).

7. Sensor nach Anspruch 6, der eine Schaltung aufweist zum Steuern der zweiten und dritten Schalter (T6, T7) mit einem zweiten Signal (H1) und der vierten und fünften Schalter (T8, T9) mit einem dritten Signal (H2), wobei die zweiten und dritten Signale an der Modulationsfrequenz und nicht überlappend sind, das heißt dass, wenn eines der zweiten und dritten Signale in dem hohen Zustand ist, das andere von der zweiten und dritten Signale in dem niedrigen Zustand ist.

8. Sensor nach einem der Ansprüche 1 bis 7, **dadurch gekennzeichnet, dass** er in einer integrierten Art und Weise ausgebildet ist.

9. Sensor nach einem der Ansprüche 1 bis 8, wobei die Modulationsfrequenz in dem Bereich von 10 kHz bis 1MHz liegt.

10. Sensor nach einem der Ansprüche 1 bis 9, der Folgendes aufweist: für jedes Pixel einen Detektor (34), der geeignet ist zum Liefern eines Signals (S₄), das repräsentativ für die modulierte Strahlung ist, und wenigstens einen Verstärker (36, 38), der das repräsentative Signal empfängt und geeignet ist zum Liefern eines verstärkten Signals (S₆), wobei der Synchronfilter (40, 60, 75, 80) das verstärkte Signal empfängt.

11. Sensor nach einem der Ansprüche 1 bis 10, wobei die Strahlung in der Abwesenheit einer Modulation eine Frequenz in dem Bereich von 100 GHz bis 30 THz besitzt.

12. Ein System (10) des Terahertz-Abbildens eines Objekts (16), das Folgendes aufweist:
eine Quelle (12) einer Terahertz-Strahlung, die durch ein Signal mit einer Modulationsfrequenz moduliert ist; und
den Sensor (20) nach einem der Ansprüche 1 bis 11 für die modulierte Terahertz-Strahlung, die von dem Objekt

## Claims

1. A terahertz array image sensor (20) comprising an array of pixels (Pix1, Pix2, Pix3, Pix4) and comprising, for each pixel, an antenna (32) for receiving a terahertz radiation (S₂) modulated by a signal at a modulation frequency, **characterized in that** it further comprises an N-path synchronous filter (40, 60, 75, 80), where N is an integer greater than or equal to 4, each path comprising a capacitive element (72ᵢ, 78ᵢ) and at least a first switch (T1ᵢ, T2ᵢ, T3ᵢ) controlled by a first signal (Pᵢ) at said modulation frequency.

2. The sensor of claim 1, wherein each path further comprises a first resistive element (70ᵢ).

3. The sensor of claim 1, wherein each path comprises one of the at least a first switch (T3ᵢ) in series with the capacitive element (78ᵢ), a plurality of paths being arranged in parallel between a first node (77, 93, 95) and a source (50) of a reference potential.

4. The sensor of claim 3, wherein the synchronous filter (75; 80) further comprises a second resistive element (76; 82) connected to the first node (77, 93, 95).

5. The sensor of claim 4, wherein the second resistive element (82) is formed by a switched-capacitance circuit.

6. The sensor of claim 4 or 5, comprising:
a first set of N/2 paths, the paths of the first set being arranged in parallel between the first node (93) and the source (50) of the reference potential;
a second switch (T6) between a second node (88) and the first node (93) and a third switch (T7) between the first node (93) and a third node (62);
a second set of N/2 paths, the paths of the second set being arranged in parallel between a fourth node (95) and the source (50) of the reference potential; and
a fourth switch (T8) between the second node (88) and the fourth node (95) and a fifth switch (T9) between the fourth node (95) and the third node (62).

7. The sensor of claim 6, comprising a circuit for controlling the second and third switches (T6, T7) with a second signal (H1) and the fourth and fifth switches (T8, T9) with a third signal (H2), the second and third signals being at the modulation frequency and being non-overlapping, that is to say that when one of the second and third signals is in the high state, the other one of the second and third signals is in the low state.

8. The sensor of any of claims 1 to 7, **characterized in that** it is formed in integrated fashion.

9. The sensor of any of claims 1 to 8, wherein the modulation frequency is in the range from 10 kHz to 1 MHz.

10. The sensor of any of claims 1 to 9, comprising, for each pixel, a detector (34) capable of delivering a signal (S₄) representative of the modulated radiation and at least one amplifier (36, 38) receiving the representative signal and capable of delivering an amplified signal (S₆), the synchronous filter (40, 60, 75, 80) receiving the amplified signal.

11. The sensor of any of claims 1 to 10, wherein the radiation, in the absence of a modulation, has a frequency in the range from 100 GHz to 30 THz.

12. A system (10) of terahertz imaging of an object (16) comprising:
a source (12) of a terahertz radiation modulated by a signal at a modulation frequency; and
the sensor (20) of the modulated terahertz radiation returned by the object of any of claims 1 to 11.
